# FASCICULE DE BREVET EUROPEEN

(11) **EP 0 499 553 B1**
(45) Date de publication et mention de la délivrance du brevet: **12.12.2001**
(21) Numéro de dépôt: 92420044.7
(22) Date de dépôt: 10.02.1992
(51) Int. Cl.: H01L 27/102, H04B 3/28, H04M 1/00

(54) **Structure monolithique comprenant deux ensembles de diodes de protection bidirectionnelles**
Monolitische Struktur beinhaltend zwei Einheiten von bidirektionalen Schutzdioden
Monolithic structure comprising two sets of bidirectional protection diodes

(30) Priorité: 12.02.1991 FR 9101975
(43) Date de publication de la demande: 19.08.1992
(73) Titulaire: STMicroelectronics S.A., 94250 Gentilly (FR)
(72) Inventeur: Anceau, Christine, F-37390 Saint Roch (FR)
(74) Mandataire: de Beaumont, Michel

(56) Documents cités:
- EP-A- 0 318 404
- FR-A- 2 624 320
- IEEE INTERNATIONAL SOLID-STATE CIRCUITS CONFERENCE 16 Février 1973, NEW YORK, N. Y., USA pages 182 - 183; W. F. DAVIS: 'MONOLITHIC BIPOLAR DESIGN CONSIDERATIONS FOR THE AUTOMOTIVE ENVIRONMENT'

## Description

La présente invention concerne la réalisation de diodes de protection. On appelle ici diodes de protection des diodes qui écrêtent la tension à leurs bornes dès que celle-ci atteint une valeur déterminée, dite tension de claquage, selon l'une ou l'autre polarité. De telles diodes sont couramment utilisées à l'entrée de dispositifs électroniques susceptibles de recevoir des parasites, tels que les circuits reliés à des lignes téléphoniques. En pratique, ces diodes doivent avoir une tension de claquage déterminée avec précision (usuellement 5 à 10 %) pour ne pas perturber le circuit qu'elles sont destinées à protéger.

Une réalisation intégrée de plusieurs diodes bidirectionnelles ayant les mêmes caractéristiques et formées dans un substrat monolithique est décrite dans EP-A-318 404.

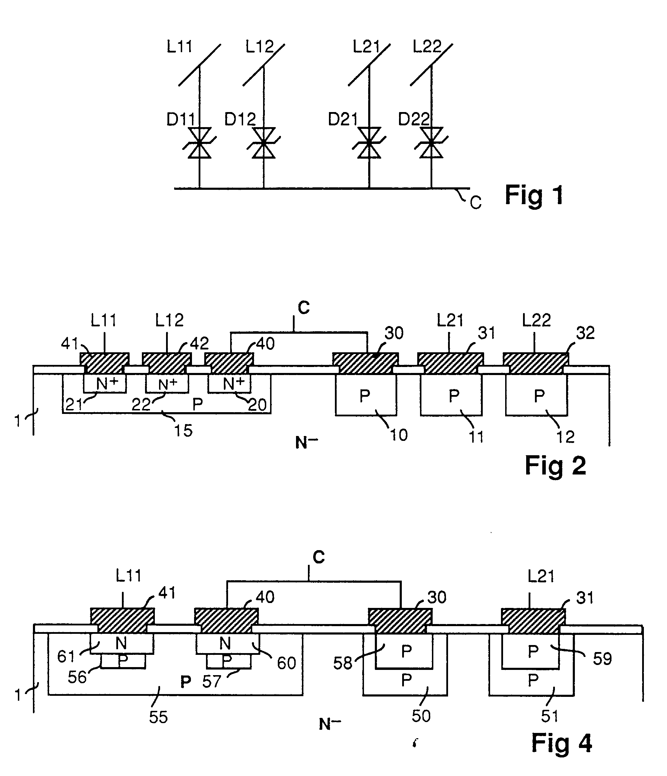

La présente invention vise plus particulièrement le cas où l'on souhaite protéger des premières lignes par rapport à des surtensions d'un premier niveau et des deuxième lignes par rapport à des surtensions d'un deuxième niveau. Ceci est illustré schématiquement en figure 1 dans laquelle on a représenté un premier ensemble de lignes L11, L12... et un deuxième ensemble de lignes L21, L22... On souhaite protéger le premier ensemble de lignes par rapport à une borne commune C par des premières diodes à claquage bidirectionnel D11, D12... et le deuxième ensemble de lignes par des deuxièmes diodes à claquage bidirectionnel D21, D22... Les diodes D11, D12... du premier ensemble claquent quand la tension à leurs bornes dépasse en valeur absolue une valeur V1 et les diodes D21, D22... du deuxième ensemble claquent quand la tension à leurs bornes dépasse en valeur absolue une tension V2. Dans ce qui suit, on considérera que V2 est supérieur à V1.

Pour assurer une protection du type de celle requise en figure 1, on a utilisé dans l'art antérieur des diodes de protection discrètes ou bien des circuits monolithiques incorporant chacun un ensemble de diodes de protection de tension de claquage prédéterminée. Dans les deux cas, il reste à effectuer des travaux d'assemblage qui sont longs et parfois complexes.

Ainsi, un objet de la présente invention est de prévoir une structure intégrée monolithique unique rassemblant deux ensembles de diodes de protection, chacun de ces ensembles ayant des caractéristiques de claquage distinctes.

Un autre objet de la présente invention est de prévoir une telle structure qui soit simple à fabriquer pour des couples de tensions de claquage déterminés.

Pour atteindre cet objet, la présente invention prévoit une structure monolithique comprenant deux ensembles de diodes bidirectionnelles de caractéristiques distinctes constituées à partir d'un substrat d'un premier type de conductivité à partir d'une surface duquel sont réalisées des premières régions du deuxième type de conductivité pour constituer le premier ensemble de diodes entre une première métallisation solidaire de l'une des premières régions et des deuxièmes métallisations solidaires des autres des premières régions. Cette structure comprend un caisson du deuxième type de conductivité formé à partir de ladite surface dans lequel sont formées des deuxièmes régions du premier type de conductivité pour constituer le deuxième ensemble de diodes entre une troisième métallisation solidaire de l'une des deuxièmes régions et des quatrièmes métallisations solidaires des autres des deuxièmes régions.

Selon un aspect de la présente invention, des couches du deuxième type de conductivité plus dopées que le caisson sont prévues à l'interface entre les fonds des deuxièmes régions et le caisson.

Ces objets, caractéristiques et avantages ainsi que d'autres de la présente invention seront exposés plus en détail dans la description suivante de modes de réalisation particuliers en relation avec les figures jointes parmi lesquelles :
la figure 1 décrite précédemment représente des diodes de protection de lignes ;
la figure 2 représente un premier mode de réalisation de la présente invention ;
les figures 3A-3B représentent des courbes de concentration de dopant en fonction de la profondeur dans deux réalisations particulières du premier mode de réalisation de la présente invention ;
la figure 4 représente un deuxième mode de réalisation de la présente invention ; et
les figures 5A-5B représentent des courbes de concentration de dopant en fonction de la profondeur dans deux réalisations particulières du deuxième mode de réalisation de la présente invention.

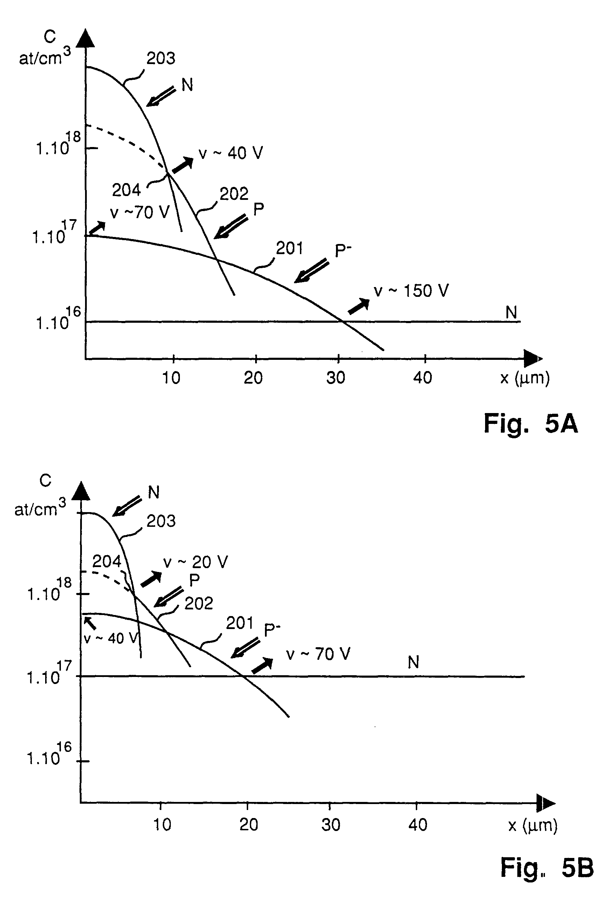

On notera que les structures des figures 2 et 4 sont représentées de façon très schématique et ne sont pas tracées à l'échelle comme cela est usuel dans le domaine de la représentation des composants semiconducteurs. Les diverses dimensions ont été arbitrairement agrandies pour faciliter la lisibilité des figures. De même, alors que les diverses régions et caissons diffusés sont illustrés avec des coins carrés, l'homme de l'art notera qu'en pratique les coins de jonction sont arrondis par suite des étapes de diffusion et de recuit.

Comme le représente la figure 2, le premier mode de réalisation de la présente invention est constitué à partir d'un substrat semiconducteur 1 généralement faiblement dopé selon un premier type de conductivité, ici N⁻. Dans une première partie de ce substrat sont formées des régions de type P 10, 11, 12 et dans une deuxième partie de ce substrat est formé un caisson de type P 15. Les régions 10, 11, 12 et le caisson 15 peuvent résulter d'une même étape de diffusion. A l'intérieur du caisson 15 sont formées des régions de type N⁺ 20, 21, 22. Chacune des régions 10, 11, 12 est recouverte d'une métallisation 30, 31, 32 et chacune des régions 20, 21, 22 est recouverte d'une métallisation 40, 41, 42.

Pour réaliser un montage du type de celui de la figure 1, les métallisations 30 et 40 seront reliées à la borne C ; les métallisations 31, 32 aux lignes L21 et L22 et les métallisations 41, 42 aux lignes L11, L12. On obtient ainsi des premières diodes de protection bidirectionnelles entre les lignes L21, L22 et la borne C et des deuxièmes diodes de protection bidirectionnelles entre les lignes L11, L12 et la borne C. Les deuxièmes diodes de protection bidirectionnelles comprennent une jonction PN entre les régions P11, 12 et le substrat N⁻ et une jonction NP entre le substrat N⁻ et la région P 10. Les premières diodes bidirectionnelles comprennent une jonction NP entre les régions N⁺ 21, 22 et le caisson P et une jonction PN entre le caisson P et la région N 20. Ces diodes sont donc bien symétriques.

La tension de claquage des diodes formées entre les régions 10, 11, 12 et le substrat N⁻ dépend essentiellement du dopage de la couche la moins dopée, le substrat N⁻, et du profil de diffusion de la jonction P/N⁻. La tension de claquage des diodes formées entre les régions N⁺ 20, 21, 22 et le caisson P dépend essentiellement du niveau de dopage de ce caisson qui est lui-même plus dopé que le substrat. Ainsi, les diodes formées dans le caisson auront une tension de claquage plus faible que celles formées directement dans le substrat. D'autre part, si le caisson P 15 est identique aux régions P 10, 11, 12, la jonction entre ce caisson et le substrat aura la même tension de claquage que la jonction entre les régions 10, 11, 12 et le substrat et l'on évite le risque qu'une tension haute sur l'une des lignes L21 et L22 puisse provoquer un claquage se refermant sur l'une des lignes L11 et L12. De façon plus générale, il conviendra que la tension de claquage entre le caisson P 15 et le substrat 1 soit supérieure ou égale à la tension de claquage entre les régions P 10, 11, 12 et ce substrat.

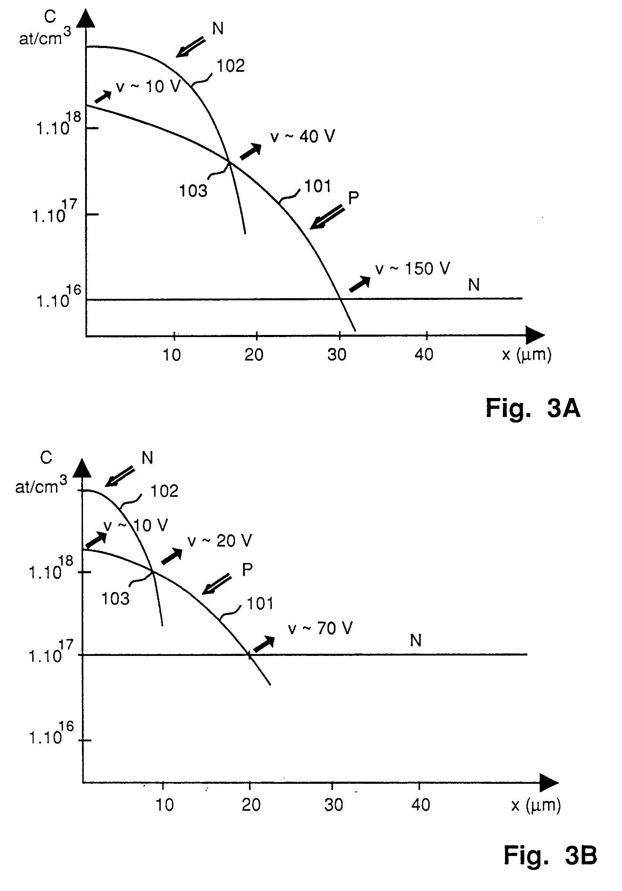

Les figures 3A et 3B illustrent des exemples de profils de diffusion pour une structure du type de celle de la figure 2. On considère que le substrat N⁻ est à un niveau de dopage homogène. C'est par exemple un substrat massif ou une couche épitaxiée formée sur un substrat. On considère également que les différentes régions ou caissons dopés résultent de diffusions et de recuits réalisés à partir de prédépôts de substances dopées à la surface de ces régions et caissons. Bien entendu, diverses variantes dans les modes de diffusion et de recuit pourraient être imaginées par l'homme de l'art. Celui-ci pourrait remplacer les étapes de diffusion à partir d'un pré-dépôt par des étapes d'implantation suivies de recuits. Les profils de dopage illustrés en figures 3A et 3B correspondent aux profils finaux après les dernières étapes de recuit.

Dans le cas de la figure 3A, le niveau de dopage du substrat est de 10¹⁶ atomes/cm³ ce qui correspondra à une tension de claquage de l'ordre de 150 volts. Par contre, le caisson 15 présente un niveau de dopage inhomogène, qui va en décroissant depuis la surface (x=0) vers le fond de ce caisson comme cela est indiqué par la courbe 101. De même, les régions N 20, 21, 22 ont un niveau de dopage qui va en décroissant de la surface vers le fond comme cela est indiqué par la courbe 102. Ainsi, au niveau de la surface, cette région N est en contact avec le caisson P à un emplacement (x=0) où ce caisson P est fortement dopé (concentration supérieure à 10¹⁸ atomes/cm³). Il en résulte une tension de claquage en surface de l'ordre d'une dizaine de volts. Par contre, si l'on considère l'intersection des courbes 101 et 102, au point 103, qui correspond au fond des régions 20, 21, 22, la tension de claquage serait de 40 volts. Toutefois, cette tension de claquage au point 103 n'intervient pas dans le fonctionnement du dispositif puisque le claquage se produira d'abord en surface pour la valeur de tension la plus faible.

La figure 3B représente une autre configuration de dopage dans laquelle le substrat est dopé à 10¹⁷ atomes/cm³ de type N, d'où il résulte une tension de claquage de 70 volts environ pour les diodes formées entre les régions P 10, 11, 12 et le substrat 1. On a représenté une courbe 101 correspondant à la diffusion de type P sensiblement identique à la courbe 101 de la figure 3A. En effet, avec les techniques usuelles de dopage par prédépôt, on sait mal faire varier la concentration en surface. La tension de claquage basse restera donc sensiblement égale à 10 volts comme dans le cas précédent et ne pourra pas être modifiée de façon notable ce qui confère peu de souplesse pour la fabrication d'une telle structure. En effet, une prolongation des temps de recuit diminuera peu la concentration en surface mais modifiera principalement la position du point 103 d'intersection entre les courbes 101 et 102.

Pour éviter cet inconvénient, la présente invention prévoit aussi une structure, illustrée en figure 4, permettant de fixer plus facilement la valeur des tensions de claquage haute et basse. Cette structure est constituée à partir d'un substrat 1 faiblement dopé d'un premier type de conductivité (N⁻). Dans ce substrat, on retrouve d'une part des régions de type P 50, 51, d'autre part un caisson de type P 55. Au cours d'une étape de masquage ultérieure, sont réalisées dans le caisson des diffusions de type P plus fortement dopées 56, 57 puis des régions de type N 60, 61. Les régions 60, 61 sont réalisées en alignement avec les régions 56 et 57 et sur une plus grande largeur de sorte que ces régions 56 et 57 occupent le fond des régions 60 et 61 sans déborder sur les côtés de ces régions. On a également représenté à l'intérieur de la région P 50 une région P plus dopée 58 et à l'intérieur de la région P 51 une région P plus dopée 59, ces régions 58 et 59 étant formées au cours de la même étape que les diffusions 56 et 57. Ensuite, des métallisations 30, 31, 40, 41 sont formées pour contacter les régions 58, 59, 60 et 61. En utilisation, la région 59 est reliée à une ligne L21, les régions 58 et 60 à une borne commune C et la région 61 à une ligne L11. Les métallisations 30 et 40 peuvent être connectées directement sur la puce par réalisation d'une métallisation continue entre les régions 58 et 60.

On notera que dans le cas de la figure 2, on a représenté la réalisation de deux diodes bidirectionnelles haute tension et de deux diodes bidirectionnelles basse tension tandis que dans la figure 4, on a représenté une seule diode bidirectionnelle haute tension et une seule diode bidirectionnelle basse tension. L'homme de l'art notera que dans les deux cas on aurait pu choisir un nombre quelconque de diodes bidirectionnelles, éventuellement nettement supérieur à 2 si le circuit à protéger comprend un plus grand nombre de lignes.

Dans la structure de la figure 4, le fonctionnement des diodes haute tension correspondant aux régions P 50 et 51 formées directement dans le substrat est similaire à celui de la figure 2. Les régions surdopées 58 et 59 sont destinées à assurer un meilleur contact ohmique avec les métallisations, étant donné que, comme on le verra ci-après, les régions P 50 et 51 sont plus faiblement dopées que les régions 10, 11, 12 de la figure 2.

La spécificité du mode de réalisation de la figure 4 réside essentiellement dans la structure des diodes basse tension formées dans le caisson 55. En effet, ce caisson P 55 est faiblement dopé de sorte que, au niveau de la jonction entre les régions P 56 et 57 et les régions N 60 et 61, le niveau de dopage des régions P 56 et 57 est plus élevé que le niveau de dopage du caisson P 55, même en surface.

Des exemples pratiques de réalisation de la structure de la figure 4 sont illustrés en figures 5A et 5B.

Dans le cas de la figure 5A, le niveau de dopage du substrat 1 est de l'ordre de 10¹⁶ atomes/cm³ d'où il résultera une tension de claquage pour le deuxième ensemble de diodes bidirectionnelles de l'ordre de 150 volts. La courbe 201 illustre le profil de concentration du caisson P 15 (et des régions P 50, 51). La courbe 202 représente le profil de diffusion des régions P 56 et 57. La courbe 203 représente le profil de concentration des régions N 60, 61. La tension de claquage des jonctions PN 56-61 et 57-60 correspond au point de fonctionnement 204. Dans l'exemple représenté, cette tension de claquage est de l'ordre de 40 volts. On notera que cette valeur est inférieure à la tension de claquage, de l'ordre de 70 volts, apparaissant au niveau de la jonction superficielle des régions N 60, 61 avec le caisson 55. Ce sont donc bien les jonctions 56, 61 et 57, 60 qui déterminent la tension de claquage du premier ensemble de diodes bidirectionnelles.

Le niveau de dopage au niveau du point 204 peut être ajusté en réglant convenablement les durées de recuit qui, rappelons-le, n'affectent sensiblement pas les valeurs des dopages en surface.

Ceci est illustré par la figure 5B où l'on a choisi une tension de claquage haute de l'ordre de 70 volts (niveau de dopage du substrat de l'ordre de 10¹⁷ atomes/cm³). Dans le cas représenté, la tension déterminée par le point 204 est de l'ordre de 20 volts alors que la tension déterminée en surface par le contact entre les régions N 60, 61 et le caisson 55 est de l'ordre de 40 volts et n'a donc pas d'influence sur le fonctionnement du système.

Ainsi, la présente invention prévoit d'une part, comme cela a été décrit en relation avec la figure 2, la réalisation d'une structure monolithique incorporant deux ensembles de diodes de protection bidirectionnelles ayant respectivement des tensions de claquage haute et basse, d'autre part, comme cela a été décrit en relation avec la figure 4, une telle structure monolithique présentant l'avantage d'un réglage simple des tensions de claquage haute et basse.

Bien entendu, la présente invention est susceptible de nombreuses variantes et modifications qui apparaîtront à l'homme de l'art qui pourra notamment inverser tous les types de conductivité décrits.

## Revendications

1. Structure monolithique comprenant deux ensembles de diodes de protection bidirectionnelles (D11, D12 ; D21, D22), chaque diode bidirectionnelle comprenant deux diodes à claquage têtebêche qui écrêtent la tension à leurs bornes dès que celle-ci atteint une valeur prédéterminée selon l'une ou l'autre polarité, de caractéristiques distinctes constituées à partir d'un substrat 1 d'un premier type de conductivité (N⁻) à partir d'une surface duquel sont réalisées des premières régions (10, 11, 12 ; 50, 51) du deuxième type de conductivité pour constituer le premier ensemble de diodes entre une première métallisation (30) solidaire de l'une des premières régions et des deuxièmes métallisations (31, 32) solidaires des autres des premières régions,
ladite structure monolithique comprenant un caisson (15 ; 55) du deuxième type de conductivité formé à partir de ladite surface dans lequel sont formées des deuxièmes régions (20, 21, 22 ; 60, 61) du premier type de conductivité pour constituer le deuxième ensemble de diodes entre une troisième métallisation (40) solidaire de l'une des deuxièmes régions et des quatrièmes métallisations (41, 42) solidaires des autres des deuxièmes régions.

2. Structure monolithique selon la revendication 1, **caractérisée en ce qu'**elle comprend des couches (56, 57) du deuxième. type de conductivité plus dopées que le caisson (55) à l'interface entre les fonds des deuxièmes régions (60, 61) et le caisson.

## Claims

1. A monolithic structure comprising two sets of bidirectional diodes (D11, D12; D21, D22), each bidirectional diode comprising two head to tail breakdown diode that clip the voltage at their terminals when this voltage reaches a predetermined value according to one or the other polarity, having distinct characteristics constituted from a substrate (1) of a first (N⁻) conductivity type, from a surface of which are formed first regions (10, 11, 12; 50, 51) of the second conductivity type for constituting the first set of diodes between a first metallization (30) coating one of the first regions and second metallizations (31, 32) coating the other first regions;
said monolithic structure comprising a well (15; 55) of the second conductivity type formed from said surface, in which are formed second regions (20, 21, 22; 60, 61) of the first conductivity type for constituting the second set of diodes between a third metallization (40) coating one of the second regions and fourth metallizations (41, 42) coating the other second regions.

2. A monolithic structure according to claim 1, **characterized in that** it comprises layers (56, 57) of the second conductivity type more highly doped than the well (55) at the interface between the bottoms of the second regions (60, 61) and the well.

## Patentansprüche

1. Monolithisches Bauteil mit zwei Gruppen von bidirektionalen Schutzdioden (D11, D12; D21, D22), wobei jede bidirektionale Diode jeweils zwei antiparallel angeordnete Durchbruchdioden umfaßt, welche die Spannung an ihren Anschlüssen abschneiden, sobald diese einen vorgegebenen Wert gemäß der einen oder der anderen Polarität bzw. Polung erreicht, wobei die beiden Durchbruchdioden unterschiedliche Kenngrößen besitzen und in einem Substrat (1) eines ersten Leitfähigkeitstyps (N⁻) ausgebildet sind, in welchem von einer ersten Oberfläche des Substrats ausgehend erste Bereiche (10, 11, 12; 50, 51) des zweiten Leitfähigkeitstyps ausgebildet sind zur Bildung der ersten Gruppe von Dioden zwischen einer mit einem der ersten Bereiche verbundenen ersten Metallisierung (30) und mit den anderen ersten Bereichen verbundenen zweiten Metallisierungen (31, 32),
wobei das genannte monolithische Bauteil einen ausgehend von der genannten Oberfläche ausgebildeten Kasten bzw. Graben (15; 55) umfaßt, in welchem zweite Bereiche (20, 21, 22; 60, 61) des ersten Leitfähigkeitstyps ausgebildet sind zur Bildung der zweiten Gruppe von Dioden zwischen einer mit einem der zweiten Bereiche verbundenen dritten Metallisierung (40) und mit den anderen zweiten Bereichen verbundenen vierten Metallisierungen (41, 42).

2. Monolithisches Bauteil nach Anspruch 1, **dadurch gekennzeichnet, daß** es stärker als der Kasten bzw. Graben (55) dotierte Schichten (56, 57) vom zweiten Leitfähigkeitstyp an der Grenzfläche zwischen den Böden der zweiten Bereiche (60, 61) und dem Kasten bzw.Graben umfaßt.
